# EUROPÄISCHE PATENTSCHRIFT

(11) **EP 1 866 358 B1**
(45) Veröffentlichungstag und Bekanntmachung des Hinweises auf die Patenterteilung: **23.07.2014**
(21) Anmeldenummer: 06829537.7
(22) Anmeldetag: 12.12.2006
(51) Int. Cl.: C08G 59/40

(54) **HALOGENFREIE FLAMMGESCHÜTZTE EPOXIDHARZ-FORMULIERUNGEN**
HALOGEN-FREE FLAME-RETARDANT EPOXY RESIN FORMULATIONS
FORMULATIONS DE RÉSINES ÉPOXYDES IGNIFUGÉES SANS HALOGÈNES

(30) Priorität: 31.03.2006 DE 102006015084
(43) Veröffentlichungstag der Anmeldung: 19.12.2007
(73) Patentinhaber: Schill + Seilacher "Struktol" GmbH, 22113 Hamburg (DE)
(72) Erfinder: JUST, Berthold, 22397 Hamburg (DE); KELLER, Holger, 21391 Reppenstedt (DE); DÖRING, Manfred, 76744 Wörth-Büchelberg (DE); STORZER, Uwe, 72076 Tübingen (DE); SEIBOLD, Sebastian, 30880 Laatzen (DE)
(74) Vertreter: Prinz & Partner
(86) Internationale Anmeldenummer: PCT/EP2006/011956
(87) Internationale Veröffentlichungsnummer: WO 2007/118507

(56) Entgegenhaltungen:
- WO-A-2004/024791
- US-A1- 4 621 123
- US-A1- 2002 035 233
- US-A1- 2003 073 781
- TOSHIO KOIZUMI, E.A.: "Pd(O) catalyzed polyaddition of bifunctional vinyloxiranes with 1,3-dicarbonyl compounds" JOURNAL OF POLYMER SCIENCE :PART A :POLYMER CHEMISTRY, Bd. 40, 2002, Seiten 2487-2494, XP002426319
- DATABASE WPI Week 200238 Derwent Publications Ltd., London, GB; AN 2002-343938 XP002426355 & JP 2001 354685 A (DAINIPPON INK & CHEM INC) 25. Dezember 2001 (2001-12-25)
- DATABASE WPI Week 200242 Derwent Publications Ltd., London, GB; AN 2002-393608 XP002426354 & WO 02/14334 A1 (NIPPON KAYAKU KK) 21. Februar 2002 (2002-02-21)
- DATABASE WPI Week 198035 Derwent Publications Ltd., London, GB; AN 1980-61124C XP002426356 & JP 55 092327 A (TOKUYAMA SODA KK) 12. Juli 1980 (1980-07-12)

## Beschreibung

Die Erfindung betrifft ein Verfahren zur Herstellung halogenfreier, flammfest ausgerüsteter Epoxidharze sowie die nach diesem Verfahren erhältlichen halogenfreien, flammfest ausgerüsteten Epoxidharze und deren Verwendung.

Aus EP 0 806 429 A2 sind bereits halogenfreie, flammfeste Epoxidharze und Phosphinsäure-Derivate als halogenfreie Flammschutzmittel für solche Epoxid-harze bekannt. Auch ist daraus die Verwendung der halogenfreien, flammfest ausgerüsteten Epoxidharze zur Herstellung von Prepregs und Verbundwerkstoffen, von Fasern, Vliesen und Geweben sowie von Leiterplatten bekannt. Ein bevorzugtes und für diese Zwecke bekanntes Phosphinsäurederivat ist 9,10-Dihydro-9-oxa-10-phospha-phenanthren-10-oxid, das in der älteren Literatur als "DOP", in der englischen Literatur überwiegend als "DOPO" bezeichnet wird.

Die Umsetzung von DOPO mit ungesättigten Mono- und Dicarbonsäuren, Anhydriden und Estern ungesättigter Carbonsäuren zur Herstellung reaktiver Flammschutzmittel, die während des Polymerisationsprozesses von Polyestern in die Polymerkette eingebaut werden können, sind aus DE 26 46 218 A1 bekannt.

Die Addition von Aldehyden und Ketonen an DOPO und andere Phosphinsäurederivate zur Herstellung von aminischen Härtern für Epoxidharze ist bekannt aus WO 2004/024791 A1.

Flammgeschützte Epoxidharze wurden auch bereits durch Umsetzung von Epoxiden mit Diolen realisiert, welche durch Veresterung von Phosphorsäure-und Phosphinsäurederivaten mit Hydrochinon erhältlich sind, vgl. z.B. US 2002/0035233 A1, Polymer 2000, Nr. 41, Seite 3631; J. Polymer Sci., Teil A, 2002, Vol. 40, Seite 369.

Mit den hier skizzierten bekannten Verfahren sind nur geringe Phosphorgehalte in den zur Addition mit den Epoxidharzen vorgesehenen Polyolen erreichbar. Für eine gute Flammschutzwirkung kommt es aber auf einen hohen Phosphorgehalt an, der jedoch andererseits nicht dazu führen darf, daß die physikalischen Eigenschaften des Polymerisats beeinträchtigt oder gar zerstört werden. Ein verfahrenstechnischer Nachteil der bisher bekanntgewordenen Verfahren bestand darin, daß eine direkte Umsetzung der für die Flammschutzeigenschaften verantwortlichen Komponenten mit dem flammfest auszurüstenden Epoxidharz nicht gelungen ist.

Der Erfindung liegt die Aufgabe zugrunde, die Nachteile der beschriebenen bekannten Verfahren zu vermeiden und neue Mittel und Wege für eine direkte Flammfestmachung von Epoxidharzen mit polyfunktionellen Phosphinsäurederivaten mit hohem Phosphorgehalt bereitzustellen.

Diese Aufgabe wird erfindungsgemäß gelöst durch ein Verfahren zur Herstellung halogenfreier, flammfest ausgerüsteter Epoxidharze, bei dem ein halogenfreies Epoxidharz mit einem polyfunktionellen Aldehyd oder Keton und mit einem Phospinsäurederivat umgesetzt wird, wobei das Phospinsäurederivat mindestens eine P-H-aktive Struktureinheit = PH(O) enthält und in einer der Polyfunktionalität des Aldehyds oder Ketons äquivalenten Menge eingesetzt wird.

Die der Erfindung zugrunde liegende Aufgabe wird ferner durch ein halogenfreies, flammfest ausgerüstetes Epoxidharz und reaktive Zwischenprodukte in Form von Polyolen gelöst, die erhältlich sind durch das erfindungsgemäße Verfahren bzw. einen Teil desselben.

Und schließlich ist Gegenstand der Erfindung auch die Verwendung eines erfindungsgemäß hergestellten bzw. erfindungsgemäß erhältlichen Epoxidharzes als Basismaterial für die Herstellung von Leiterplatten und gedruckten Schaltungen.

Durch die sogenannte Michael-Addition von P-H-aktiven Verbindungen mit der Struktureinheit = PH(O) mit mindestens difunktionellen Aldehyden und Ketonen entstehen entsprechende mehrfunktionelle Alkohole oder Polyole. Diese phosphorhaltigen Polyole können direkt an Epoxidharze addiert werden, gegebenenfalls unter Einsatz eines Katalysators, wie beispielsweise tertiärer Phosphane, tertiärer Amine oder eines Salzes dieser tertiären Phosphane oder Amine.

Überraschenderweise gelingt die erfindungsgemäße Umsetzung der P-H-aktiven Verbindungen mit mehrfunktionellen Aldehyden und Ketonen auch direkt im Epoxidharz, was den verfahrenstechnischen Aufwand erheblich vereinfacht und zu einer drastischen Kostenreduktion bei der Flammfestmachung von Epoxidharzen führt.

Gleichgültig, ob die Umsetzung stufenweise oder als "Eintopfreaktion" erfolgt, weisen die als Endprodukt entstehenden halogenfreien, flammfest ausgerüsteten Epoxidharze, nachdem sie in üblicher Weise gehärtet worden sind, jeweils dieselben physikalischen Eigenschaften auf.

Da die intermediär oder als Zwischenprodukte gebildeten mehrfunktionellen Alkohole jeweils mindestens zwei phosphorhaltige Gruppen tragen, ist der Phosphorgehalt des flammfest ausgerüsteten Epoxidharzes, bezogen auf die Oxiran-Äquivalente des Epoxids entsprechend höher als bei den bekannten Verfahren.

Das erfindungsgemäße Verfahren wird anhand des Formelschemas nachfolgend näher erläutert: 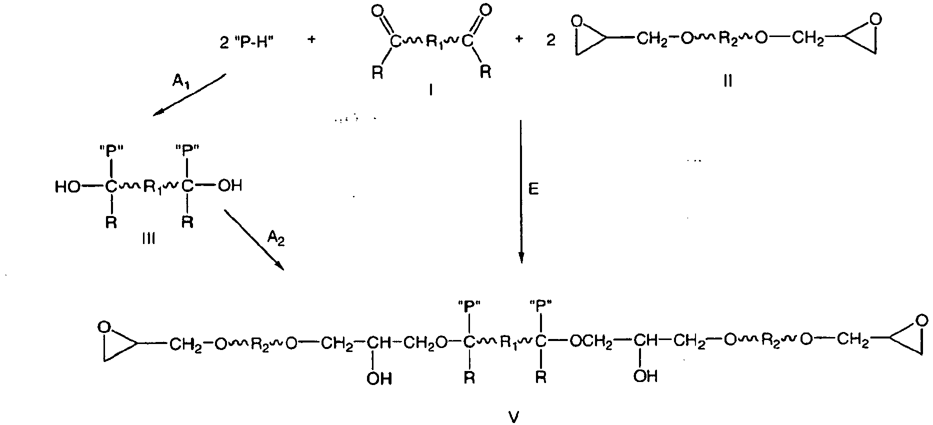
R = H, Alkyl, Aryl
R₁ = Alkylen, Arylen, auch substituiert
R₂ = Bisphenylenpropan, -methan, Novolake etc.

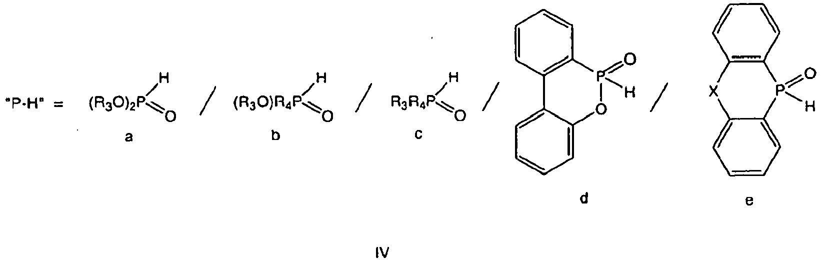

X = O, NH, N-Alkyl, S, SO, SO₂, CO
R₃ = Alkyl, Aryl
R₄ = Alkyl, Aryl

Aus Vereinfachungsgründen und zur Verbesserung der Übersicht wird im Formelschema ein Dialdehyd oder Diketon der allgemeinen Formel I mit einem Phosphinsäurederivat der allgemeinen Formel "P-H" und mit einem mindestens difunktionellen Epoxidharz der allgemeinen Formel II zu einem flammfest ausgerüsteten, modifizierten Epoxidharz der allgemeinen Formel V umgesetzt.

Die Umsetzung durch mehrfache Kondensation erfolgt entweder in einer Eintopfreaktion (Pfeil E), in der alle Komponenten gleichzeitig vermischt und gegebenenfalls unter Einsatz eines Katalysators miteinander reagieren.

Als Katalysator wird vorzugsweise ein tertiäres Phosphan, ein tertiäres Amin oder ein Salz eines tertiären Phosphans oder Amins verwendet, besonders bevorzugt Triphenylphosphin oder Triethanolamin.

Es können aber auch zunächst in einer ersten Stufe der Addition (Pfeil A₁) die P-H-aktive Verbindung an den Aldehyd oder das Keton der Formel I unter Bildung eines Diols (Zwischenprodukt) der allgemeinen Formel III addiert werden, welches - entweder ohne zuvor isoliert zu werden oder auch nach vorheriger Isolation - anschließend in einer zweiten Stufe (Pfeil A₂) mit dem mindestens difunktionellen Epoxid der allgemeinen Formel II unter Bildung des modifizierten Epoxids der allgemeinen Formel V umgesetzt wird

Mit höherfunktionellen Aldehyden und Ketonen entsteht anstelle eines Diols ganz entsprechend ein Triol, Tetrol oder höheres Polyol, das an ein mindestens difunktionelles, vorzugsweise an ein höherfunktionelles Epoxidharz addiert werden kann.

In der allgemeinen Formel I bedeutet R im Falle eines Dialdehyds Wasserstoff und im Falle eines Diketons Alkyl oder Aryl, jeweils substituiert oder unsubstituiert.

R₁ ist ein substituierter oder unsubstituierter Alkylen- oder Arylenrest.

Im Epoxid der allgemeinen Formel II bedeutet R₂ den Rest eines Bisphenylenmethans, Bisphenylenpropans oder eines Phenol-Formaldehyd-Harzes oder Novolaks.

Das Phosphinsäurederivat "P-H" besitzt eine der allgemeinen Formeln IVa, IVb, IVc, IVd oder IVe, worin R₃ und R₄, jeweils unabhängig voneinander, einen substituierten oder unsubstituierten Alkyl- oder Arylrest und X = O, NH, N-Alkyl, S, SO, SO₂ oder CO bedeuten.

Während bei der Michael-Addition der P-H-aktiven Verbindung an Aldehyde und Ketone aus jedem Carbonyl-Sauerstoffatom eine Hydroxylgruppe wird und gleichzeitig eine Kohlenstoff-Phosphor-Einfachbindung am Carbonyl-Kohlenstoffatom ausgebildet wird, entsteht bei der Addition des Diols oder Polyols an den Oxiranring einer Glycidylgruppe des Epoxids eine 2-Hydroxypropylenether-Gruppierung, wobei das modifizierte Epoxidharz noch reaktionsfähige und damit härtbare, endständige Oxiranringe trägt. Zusätzliche Vernetzungsmöglichkeiten bieten die durch die Addition des Diols entstandenen Hydroxylgruppen.

Die Umsetzung der einzelnen Komponenten erfolgt vorzugsweise bei Normaldruck und bei einer Temperatur zwischen 100 und 160°C, besonders bevorzugt bei einer Temperatur zwischen 120 und 140°C.

Als Härter für die modifizierten Epoxidharze eignen sich Dicyandiamid, 1,1-Dimethyl-3-phenylharnstoff, auch "Fenuron" genannt, Diethylentoluoldiamin (DETDA) sowie Phenolnovolake oder auch zwei oder mehrere dieser Härter in Kombination.

Als multifunktionelle Aldehyde und Ketone werden vorzugsweise Phthaldialdehyd, Terephthaldialdehyd, Isophthaldialdehyd und 1,4-Diacetylbenzol verwendet.

Als P-H-aktives Phosphinsäurederivat wird vorzugsweise DOPO eingesetzt.

Das erfindungsgemäß flammfest modifizierte Epoxidharz wird vorzugsweise als Basismaterial für die Herstellung von Leiterplatten und gedruckten Schaltungen und ganz allgemein für Elektronikanwendungen eingesetzt, weil hier der Vorteil der Halogenfreiheit und der Flammfestigkeit aus gesundheitsrechtlichen, umweltrechtlichen und arbeitsrechtlichen Gründen, aber auch aus Gründen des Korrosionsschutzes und der Betriebssicherheit von elektronischen Anlagen und Geräten von besonderer Bedeutung ist.

Die Erfindung wird anhand der folgenden Beispiele weiter erläutert:

### Darstellung der flammgehemmten Epoxidharzformulierungen

### Beispiel 1-1

200 g eines Epoxynovolakes (DEN 438) werden bei 100 °C und 10⁻² hPa für 1 h entgast und getrocknet. Anschließend wird bei Raumdruck auf 120 °C erhitzt. Bei Erreichen dieser Temperatur werden 7.69 g 9,10-Dihydro-9-oxa-10-phosphanthren-10-oxid (DOPO), 4.77 g Terephthaldialdehyd und 250 mg Triphenylphosphin zugegeben. Nach der Zugabe wird die Badtemperatur über 20 min langsam auf 160 °C erhöht und nach weiteren 10 min nochmals 7.69 g DOPO eingetragen. Die Reaktionsmischung wird noch für weitere 60 min bei 160 °C gehalten. Beim Abkühlen auf Raumtemperatur erhält man ein gelbes, festes Epoxidharz mit einem Phosphorgehalt von 1.0 %.

### Beispiel 1-2

202.6 g eines Epoxynovolakes (DEN 438) werden bei 100 °C und 10⁻² hPa für 1 h entgast und getrocknet. Anschließend wird bei Raumdruck auf 120 °C erhitzt. Bei Erreichen dieser Temperatur werden 17.32 g 9,10-Dihydro-9-oxa-10-phosphanthren-10-oxid (DOPO), 10.72 g Phthaldialdehyd und 250 mg Triphenylphosphin zugegeben. Nach der Zugabe wird die Badtemperatur über 20 min langsam auf 160 °C erhöht und nach weiteren 10 min nochmals 17.32 g DOPO eingetragen. Die Reaktionsmischung wird noch für weitere 60 min bei 160 °C gehalten. Beim Abkühlen auf Raumtemperatur erhält man ein gelbes, festes Epoxidharz mit einem Phosphorgehalt von 2.0 %.

### Beispiel 1-3

208.0 g eines Epoxynovolakes (DEN 438) werden bei 100 °C und 10⁻² hPa für 1 h entgast und getrocknet. Anschließend wird auf 120 °C erhitzt. Bei Erreichen dieser Temperatur werden 17.76 g 9,10-Dihydro-9-oxa-10-phosphanthren-10-oxid (DOPO), 11.04 g Isophthaldialdehyd und 250 mg Triphenylphosphin zugegeben. Nach der Zugabe wird die Badtemperatur über 20 min langsam auf 160 °C erhöht und nach weiteren 10 min nochmals 17.76 g DOPO eingetragen. Die Reaktionsmischung wird noch für weitere 60 min bei 160 °C gehalten. Beim Abkühlen auf Raumtemperatur erhält man ein gelbes, festes Epoxidharz mit einem Phosphorgehalt von 2.0 %.

### Beispiel 1-4

204.0 g eines Epoxynovolakes (DEN 438) werden bei 100 °C und 10⁻² hPa für 1 h entgast und getrocknet. Anschließend wird auf 120 °C erhitzt. Bei Erreichen dieser Temperatur werden 17.64 g 9,10-Dihydro-9-oxa-10-phosphanthren-10-oxid (DOPO), 13.24 g 1,4-Diacetylbenzol und 250 mg Triphenylphosphin zugegeben. Nach der Zugabe wird die Badtemperatur über 20 min langsam auf 160 °C erhöht und nach weiteren 10 min nochmals 17.64 g DOPO eingetragen. Die Reaktionsmischung wird noch für weitere 60 min bei 160 °C gehalten. Beim Abkühlen auf Raumtemperatur erhält man ein gelbes, festes Epoxidharz mit einem Phosphorgehalt von 2.0 %.

### Beispiel 1-5

200 g eines Bisphenol-A-bisglycidylethers (DER 331) werden bei 100 °C und 10⁻² hPa für 1 h entgast und getrocknet. Anschließend wird auf 120 °C erhitzt. Bei Erreichen dieser Temperatur werden 28.86 g 9,10-Dihydro-9-oxa-10-phosphanthren-10-oxid (DOPO), 17.91 g Terephthaldialdehyd und 250 mg Triphenylphosphin zugegeben. Nach der Zugabe wird die Badtemperatur über 20 min langsam auf 160 °C erhöht und nach weiteren 10 min nochmals 28.86 g DOPO eingetragen. Die Reaktionsmischung wird noch für weitere 60 min bei 160 °C gehalten. Beim Abkühlen auf Raumtemperatur erhält man ein gelbes, zähflüssiges Epoxidharz mit einem Phosphorgehalt von 3.0 %.

### Beispiel 1-6

200 g eines Epoxynovolakes (DEN 438) werden bei 100 °C und 10⁻² hPa für 1 h entgast und getrocknet. Anschließend wird auf 140 °C erhitzt. Bei Erreichen dieser Temperatur werden 75.62 g des Adduktes aus 1 Äquivalent Terephthaldialdehyd und 2 Äquivalenten 9,10-Dihydro-9-oxa-10-phosphanthren-10-oxid (DOPO) und 300 mg Triethanolamin zugegeben. Nach der Zugabe wird die Badtemperatur über 20 min langsam auf 160 °C erhöht und für weitere 60 min gehalten. Beim Abkühlen auf Raumtemperatur erhält man ein gelbes, festes Epoxidharz mit einem Phosphorgehalt von 3.0 %.

### Beispiel 1-7

105.5 g eines Epoxynovolakes (DEN 438) werden bei 100 °C und 10⁻² hPa für 1 h entgast und getrocknet. Anschließend wird auf 120 °C erhitzt. Bei Erreichen dieser Temperatur werden 16.90 g Diphenylphosphit, 9.68 g Terephthaldialdehyd und 1.60 g Triphenylphosphin zugegeben. Nach der Zugabe wird die Badtemperatur über 20 min langsam auf 160 °C erhöht und nach weiteren 10 min nochmals 16.90 g DOPO eingetragen. Die Reaktionsmischung wird noch für weitere 60 min bei 160 °C gehalten. Beim Abkühlen auf Raumtemperatur erhält man ein gelb-oranges, festes Epoxidharz mit einem Phosphorgehalt von 3.0 %.

### Beispiel 1-8

100 g eines Epoxynovolakes (DEN 438) werden bei 100 °C und 10⁻² hPa für 1 h entgast und getrocknet. Anschließend wird auf 120 °C erhitzt. Bei Erreichen dieser Temperatur werden 9.87 g 2,8-Dimethyl-phenoxaphosphin-10-oxid, 5.42 g Terephthaldialdehyd und 1.25 g Triphenylphosphin zugegeben. Nach der Zugabe wird die Badtemperatur über 20 min langsam auf 160 °C erhöht und nach weiteren 10 min nochmals 9.87 g 2,8-Dimethyl-anthracen-8-oxa-10-phosphin-10-oxid eingetragen. Die Reaktionsmischung wird noch für weitere 60 min bei 160 °C gehalten. Beim Abkühlen auf Raumtemperatur erhält man ein festes Epoxidharz mit einem Phosphorgehalt von 3.0 %.

### Aushärten der Epoxidharze

### Beispiel 2-1

135.0 g des Epoxidharzes aus Beispiel 1-1 werden mit 8.10 g Dicyandiamid (Dyhard 100 S von Degussa) und 1.35 g Fenuron (Dyhard UR 300 von Degussa) homogenisiert und gehärtet (2 h bei 130 °C, 2 h bei 180 °C). Die so dargestellte Reinharzplatte wird im UL 94 Test mit V0 klassifiziert (Plattendicke: 4 mm ± 1 mm). Die Glasübergangstemperatur (DSC) betrug 181 °C.

### Beispiel 2-2

117.0 g des Epoxidharzes aus Beispiel 1-1 werden mit 26.15 g DETDA 80 (Lonza) homogenisiert und gehärtet (2 h bei 140 °C, 2 h bei 200 °C). Die so dargestellte Reinharzplatte wird im UL 94 Test mit V0 klassifiziert (Plattendicke: 4 mm ± 1 mm). Die Glasübergangstemperatur (DSC) betrug 197 °C.

### Beispiel 2-3

138.0 g des Epoxidharzes aus Beispiel 1-1 werden mit 72.5 g Phenolnovolak (PHS 6000 IZ 02 von Hexion) homogenisiert und gehärtet (2 h bei 140 °C, 2 h bei 200 °C). Die so dargestellte Reinharzplatte wird im UL 94 Test mit V0 klassifiziert (Plattendicke: 4 mm ± 1 mm).

### Beispiel 2-4

127.0 g des Epoxidharzes aus Beispiel 1-2 werden mit 24.05 g DETDA 80 (Lonza) homogenisiert und gehärtet (2 h bei 150 °C, 2 h bei 200 °C). Die so dargestellte Reinharzplatte wird im UL 94 Test mit V0 klassifiziert (Plattendicke: 4 mm ± 1 mm). Die Glasübergangstemperatur (DSC) betrug 170 °C.

### Beispiel 2-5

122.0 g des Epoxidharzes aus Beispiel 1-3 werden mit 21.46 g DETDA 80 (Lonza,)homogenisiert und gehärtet (2 h bei 140 °C, 2 h bei 200 °C). Die so dargestellte Reinharzplatte wird im UL 94 Test mit V0 klassifiziert (Plattendicke: 4 mm ± 1 mm). Die Glasübergangstemperatur (DSC) und betrug 156 °C.

### Beispiel 2-6

128.0 g des Epoxidharzes aus Beispiel 1-4 werden mit 22.43 g DETDA 80 (Lonza) homogenisiert und gehärtet (2 h bei 140 °C, 2 h bei 200 °C). Die so dargestellte Reinharzplatte wird im UL 94 Test mit V0 klassifiziert (Plattendicke: 4 mm ± 1 mm). Die Glasübergangstemperatur betrug 167 °C.

### Beispiel 2-7

83.75 g des Epoxidharzes aus Beispiel 1-5 werden mit 13.3 g DETDA 80 (Lonza) homogenisiert und gehärtet (2 h bei 140 °C, 2 h bei 200 °C). Die so dargestellte Reinharzplatte mit V0 klassifiziert (Plattendicke: 4 mm ± 1 mm).

### Beispiel 2-8

86.5 g des Epoxidharzes aus Beispiel 1-5 werden mit 5.20 g Dicyandiamid (Dyhard 100 S von Degussa) und 0.85 g Fenuron (Dyhard UR 300 von Degussa) homogenisiert und gehärtet (2 h bei 130 °C, 2 h bei 180 °C). Die so dargestellte Reinharzplatte wird im UL 94 Test mit V klassifiziert (Plattendicke: 4 mm ± 1 mm).

## Patentansprüche

1. Verfahren zur Herstellung halogenfreier, flammfest ausgerüsteter Epoxidharze, bei dem ein halogenfreies Epoxidharz mit einem polyfunktionellen Aldehyd oder Keton und mit einem Phosphinsäure-Derivat umgesetzt wird, wobei das Phosphinsäure-Derivat mindestens eine P-H-aktive Struktureinheit =PH(O) enthält und in einer der Polyfunktionalität des Aldehyds oder Ketons äquivalenten Menge eingesetzt wird.

2. Verfahren nach Anspruch 1, **dadurch gekennzeichnet, daß** in einem ersten Schritt der polyfunktionelle Aldehyd oder das polyfunktionelle Keton mit dem Phosphinsäure-Derivat unter Bildung eines Polyols umgesetzt und das Polyol in einem zweiten Schritt an das Epoxidharz addiert wird.

3. Verfahren nach Anspruch 1 oder 2, **dadurch gekennzeichnet, daß** das Epoxidharz in Gegenwart eines Katalysators umgesetzt wird.

4. Verfahren nach Anspruch 3, **dadurch gekennzeichnet, daß** als Katalysator ein tertiäres Phosphan oder Amin oder deren Salze verwendet werden.

5. Verfahren nach Anspruch 4, **dadurch gekennzeichnet, daß** als Katalysator Triphenylphosphin oder Triethanolamin verwendet werden.

6. Verfahren nach einem der Ansprüche 1 bis 5, **dadurch gekennzeichnet, daß** die Umsetzung der Komponenten bei Normaldruck und einer Temperatur zwischen 100 und 160°C, vorzugsweise von 120 bis 140°C, durchgeführt wird.

7. Verfahren nach einem der Ansprüche 1 bis 6, **dadurch gekennzeichnet, daß** das erhaltene, flammfest ausgerüstete Epoxidharz mit Hilfe eines aminischen Härters gehärtet wird.

8. Verfahren nach Anspruch 7, **dadurch gekennzeichnet, daß** als Härter mindestens eine Verbindung aus der aus Dicyandiamid, Fenuron (1,1-Dimethyl-3-phenylharnstoff), DETDA (Diethylentoluoldiamin) und Phenolnovolaken bestehenden Gruppe verwendet wird.

9. Halogenfreies, flammfest ausgerüstetes Epoxidharz, erhältlich durch Umsetzung eines halogenfreien Epoxidharzes mit einem polyfunktionellen Aldehyd oder Keton und mit einem Phosphinsäure-Derivat, wobei das Phosphinsäure-Derivat mindestens eine P-H-aktive Struktureinheit =PH(O) enthält und in einer der Polyfunktionalität des Aldehyds oder Ketons äquivalenten Menge eingesetzt wird.

10. Epoxidharz nach Anspruch 9, **dadurch gekennzeichnet, daß** der polyfunktionelle Aldehyd bzw. das polyfunktionelle Keton eine difunktionelle Verbindung der Formel I ist 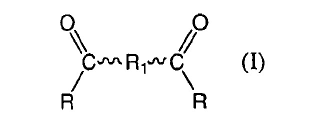 worin R ein Wasserstoffatom oder eine substituierte oder unsubstituierte Alkyl-oder Arylgruppe und R₁ eine substituierte oder unsubstituierte Alkylen- oder Arylen-Gruppe ist.

11. Epoxidharz nach Anspruch 10, **dadurch gekennzeichnet, daß** der Aldehyd bzw. das Keton ausgewählt ist aus der Gruppe Phthaldialdehyd, Terephthaldialdehyd, Isophthaldialdehyd und 1,4-Diacetylbenzol.

12. Epoxidharz nach einem der Ansprüche 9 bis 11, **dadurch gekennzeichnet, daß** das als Ausgangsmaterial eingesetzte halogenfreie Epoxidharz ein Harz der Formel II ist, 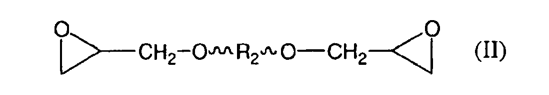 worin R₂ der Rest eines substituierten oder unsubstituierten Bisphenylenmethans, Bisphenylenpropans, eines Phenol-Formaldehyd-Harzes oder eines Novolaks ist.

13. Epoxidharz nach einem der Ansprüche 9 bis 12, **dadurch gekennzeichnet, daß** das Phosphinsäurederivat eine Verbindung der Formeln IVa - IVe ist, 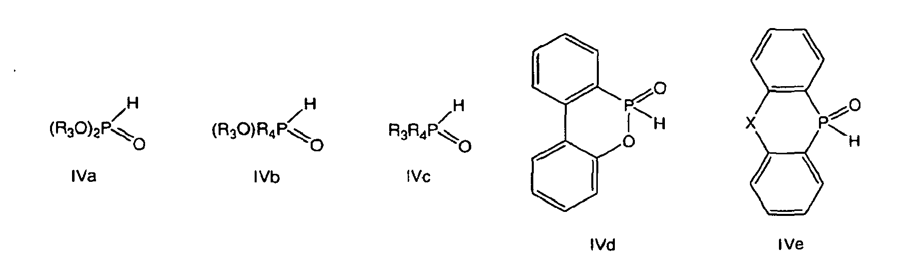
worin R₃ und R₄, unabhängig voneinander, einen substituierten oder unsubstituierten Akyl - oder Arylrest und
X = O, NH, N-Alkyl, S, SO, SO₂ oder CO
bedeuten.

14. Epoxidharz nach Anspruch 13, **dadurch gekennzeichnet, daß** das Phosphinsäurederivat 9,10-Dihydro-9-oxa-10-phospha-phenanthren-10-oxid (DOPO) ist.

15. Epoxidharz nach einem der Ansprüche 9 bis 14, **gekennzeichnet durch** die Formel V, 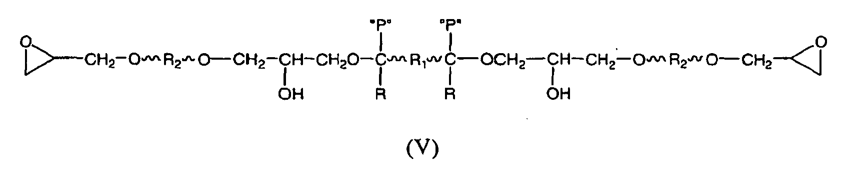 worin R, R₁ und R₂ die in den vorhergehenden Ansprüchen genannten Bedeutungen besitzen und "P" den Rest eines Phosphinsäurederivats einer der Formeln IVa - IVe bedeutet, der nach Abgabe des direkt an das Phosphoratom gebundenen Wasserstoffatoms verbleibt.

16. Verwendung des Epoxidharzes gemäß einem der Ansprüche 9 bis 15 als Basismaterial für die Herstellung von Leiterplatten und gedruckten Schaltungen.

17. Zwischenprodukt zur Herstellung des Epoxidharzes gemäß einem der Ansprüche 10 bis 15, erhältlich durch Addition eines Phosphinsäure-Derivats an einen polyfunktionellen Aldehyd oder ein polyfunktionelles Keton unter Bildung eines Polyols, wobei das Phosphinsäure-Derivat mindestens eine P-H-aktive Struktureinheit =PH(O) enthält und in einer der Polyfunktionalität des Aldehyds oder Ketons äquivalenten Menge eingesetzt wird.

18. Zwischenprodukt nach Anspruch 17, **dadurch gekennzeichnet, daß** der polyfunktionelle Aldehyd bzw. das polyfunktionelle Keton eine difunktionelle Verbindung der Formel I ist 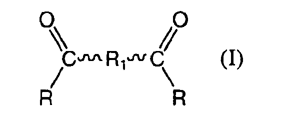 worin R ein Wasserstoffatom oder eine substituierte oder unsubstituierte Alkyl-oder Arylgruppe und R₁ eine substituierte oder unsubstituierte Alkylen- oder Arylen-Gruppe ist.

19. Zwischenprodukt nach Anspruch 18, **dadurch gekennzeichnet, daß** der Aldehyd bzw. das Keton ausgewählt ist aus der Gruppe Phthaldialdehyd, Terephthaldialdehyd, Isophthaldialdehyd und 1,4-Diacetylbenzol.

20. Zwischenprodukt nach einem der Ansprüche 17 bis 19, **dadurch gekennzeichnet, daß** das Phosphinsäurederivat eine Verbindung der Formeln IVa - IVe ist, 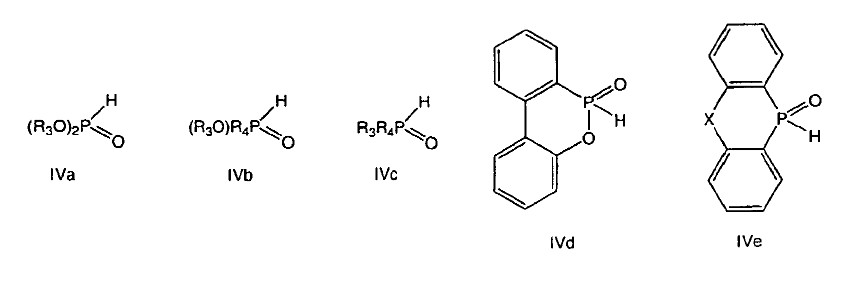
worin R₃ und R₄, unabhängig voneinander, einen substituierten oder unsubstituierten Alkyl- oder Arylrest und
X = O, NH, N-Alkyl, S, SO, SO₂ oder CO
bedeuten.

21. Zwischenprodukt nach Anspruch 20, **dadurch gekennzeichnet, daß** das Phosphinsäurederivat 9,10-Dihydro-9-oxa-10-phospha-phenanthren-10-oxid ist.

## Claims

1. A method for preparing halogen-free flameproof epoxy resins, in which a halogen-free epoxy resin is reacted with a polyfunctional aldehyde or ketone and a phosphinic acid derivative, wherein the phosphinic acid derivative contains at least one P-H-active structural unit of the formula =PH(O) and is used in an amount equivalent to the polyfunctionality of the aldehyde or ketone.

2. The method according to claim 1, **characterized in that** in a first step the polyfunctional aldehyde or the polyfunctional ketone is reacted with the phosphinic acid derivative to form a polyol, and in a second step said polyol is added to the epoxy resin.

3. The method according to claim 1 or 2, **characterized in that** the epoxy resin is reacted in the presence of a catalyst.

4. The method according to claim 3, **characterized in that** a tertiary phosphane or amine or the salts thereof are used as a catalyst.

5. The method according to claim 4, **characterized in that** triphenylphosphine or triethanolamine is used as a catalyst.

6. The method according to any one of claims 1 to 5, **characterized in that** the components are reacted at normal pressure and at a temperature between 100 and 160 °C, preferably between 120 and 140 °C.

7. The method according to any one of claims 1 to 6, **characterized in that** the flameproof epoxy resin obtained is cured by means of an amine curing agent.

8. The method according to claim 7, **characterized in that** at least one compound selected from the group consisting of dicyandiamide, fenurone (1,1-dimethyl-3-phenyl urea), DETDA (diethylene toluene diamine) and phenolic novolaks is used as a curing agent.

9. A halogen-free flameproof epoxy resin obtainable by reacting a halogen-free epoxy resin with a polyfunctional aldehyde or ketone and a phosphinic acid derivative, wherein the phosphinic acid derivative contains at least one P-H-active structural unit of the formula =PH(O) and is used in an amount equivalent to the polyfunctionality of the aldehyde or ketone.

10. The epoxy resin according to claim 9, **characterized in that** the polyfunctional aldehyde or the polyfunctional ketone is a difunctional compound of the formula I, 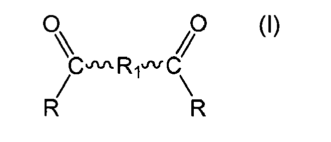 wherein R is a hydrogen atom or a substituted or unsubstituted alkyl or aryl group and R₁ is a substituted or unsubstituted alkylene or arylene group.

11. The epoxy resin according to claim 10, **characterized in that** the aldehyde or the ketone is selected from the group consisting of phthaldialdehyde, terephthaldialdehyde, isophthaldialdehyde and 1,4-diacetylbenzene.

12. The epoxy resin according to any one of claims 9 to 11, **characterized in that** the halogen-free epoxy resin used as a starting material is a resin of the formula II, 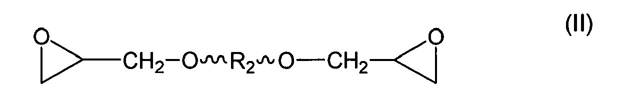 wherein R₂ is the residue of a substituted or unsubstituted bisphenylene methane, bisphenylene propane, a phenolic formaldehyde resin or a novolak.

13. The epoxy resin according to any one of claims 9 to 12, **characterized in that** the phosphinic acid derivative is a compound of the formulae IVa - IVe, 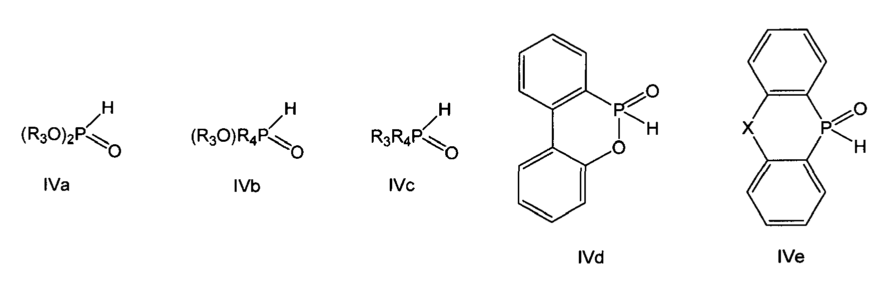
wherein R₃ and R₄ are independently a substituted or unsubstituted alkyl or aryl residue and
X = O, NH, N-alkyl, S, SO, SO₂ or CO.

14. The epoxy resin according to claim 13, **characterized in that** the phosphinic acid derivative is 9,10-dihydro-9-oxa-10-phospha-phenanthrene-10-oxide (DOPO).

15. The epoxy resin according to any one of claims 9 to 14, **characterized by** formula V, 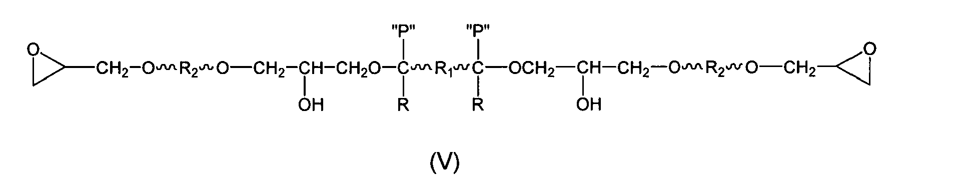 wherein R, R₁ and R₂ are each as defined in the above claims and "P" is the residue of a phosphinic acid derivative of one of the formulas IVa - IVe that is left after release of the hydrogen atom directly bound to the phosphorus atom.

16. Use of the epoxy resin according to any one of claims 9 to 15 as a base material for the manufacture of printed circuit boards and printed circuits.

17. An intermediate for the production of the epoxy resin according to any one of claims 10 to 15 obtainable by the addition of a phosphinic acid derivative to a polyfunctional aldehyde or a polyfunctional ketone to form a polyol, wherein the phosphinic acid derivative contains at least one P-H-active structural unit of the formula =PH(O) and is used in an amount equivalent to the polyfunctionality of the aldehyde or ketone.

18. The intermediate according to claim 17, **characterized in that** the polyfunctional aldehyde or the polyfunctional ketone is a difunctional compound of the formula I, 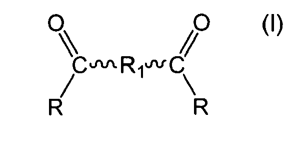 wherein R is a hydrogen atom or a substituted or unsubstituted alkyl or aryl group and R₁ is a substituted or unsubstituted alkylene or arylene group.

19. The intermediate according to claim 18, **characterized in that** the aldehyde or the ketone is selected from the group consisting of phthaldialdehyde, terephthaldialdehyde, isophthaldialdehyde and 1,4-diacetylbenzene.

20. The intermediate according to any one of claims 17 to 19, **characterized in that** the phosphinic acid derivative is a compound of the formulae IVa - IVe, 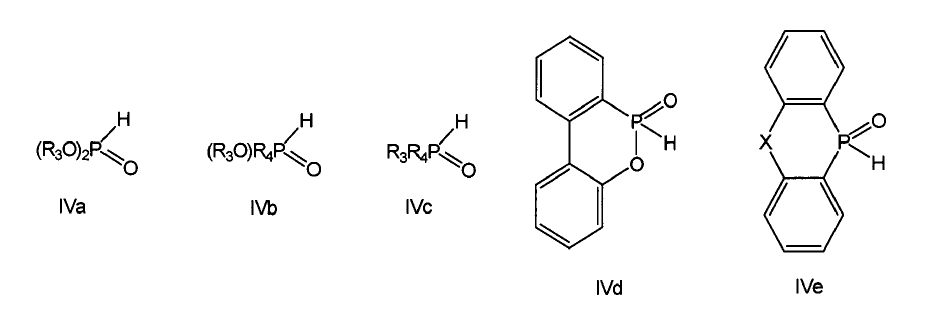
wherein R₃ and R₄ are independently a substituted or unsubstituted alkyl or aryl residue and
X = O, NH, N-alkyl, S, SO, SO₂ or CO.

21. The intermediate according to claim 20, **characterized in that** the phosphinic acid derivative is 9,10-dihydro-9-oxa-10-phospha-phenanthrene-10-oxide.

## Revendications

1. Procédé de réalisation de résines époxy exemptes d'halogène et traitées de manière à être ignifuges, dans lequel une résine époxy exempte d'halogène est amenée à réagir avec un aldéhyde polyfonctionnel ou une cétone polyfonctionnelle et avec un dérivé d'acide de phosphine, le dérivé d'acide de phosphine contenant au moins une unité structurelle à P-H actif =PH(O) et étant utilisé dans une quantité équivalente à la polyfonctionnalité de l'aldéhyde ou de la cétone.

2. Procédé selon la revendication 1, **caractérisé en ce que** dans une première étape, l'aldéhyde polyfonctionnel ou la cétone polyfonctionnelle est amené(e) à réagir avec le dérivé d'acide de phosphine de manière à former un polyol, et **en ce que** dans une deuxième étape, le polyol est additionné à la résine époxy.

3. Procédé selon la revendication 1 ou 2, **caractérisé en ce que** la résine époxy est amenée à réagir en présence d'un catalyseur.

4. Procédé selon la revendication 3, **caractérisé en ce qu'**un phosphane ou une amine tertiaire, ou leurs sels sont utilisés en tant que catalyseur.

5. Procédé selon la revendication 4, **caractérisé en ce que** de la triphénylphosphine ou de la triéthanolamine est utilisée en tant que catalyseur.

6. Procédé selon l'une des revendications 1 à 5, **caractérisé en ce que** les composants sont amenés à réagir sous pression normale et à une température entre 100 et 160°C, de préférence de 120 à 140°C.

7. Procédé selon l'une des revendications 1 à 6, **caractérisé en ce que** la résine époxy obtenue traitée de manière à être ignifuge est durcie au moyen d'un durcisseur amine.

8. Procédé selon la revendication 7, **caractérisé en ce qu'**au moins un composé parmi le groupe constitué de dicyandiamide, de fenurone (1,1-diméthyl-3-phénylurée), de DETDA (diéthylène-toluènediamine), et de phénol novolaque est utilisé en tant que durcisseur.

9. Résine époxy exempte d'halogène et traitée de manière à être ignifuge, réalisable en faisant réagir une résine époxy exempte d'halogène avec un aldéhyde polyfonctionnel ou une cétone polyfonctionnelle et avec un dérivé d'acide de phosphine, le dérivé d'acide de phosphine contenant au moins une unité structurelle à P-H actif =PH(O) et étant utilisé dans une quantité équivalente à la polyfonctionnalité de l'aldéhyde ou de la cétone.

10. Résine époxy selon la revendication 9, **caractérisée en ce que** l'aldéhyde polyfonctionnel ou la cétone polyfonctionnelle est un composé difonctionnel présentant la formule I 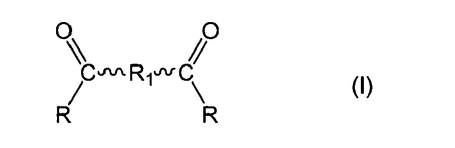 R étant un atome d'hydrogène ou un groupe alkyle ou aryle substitué ou non-substitué, et R₁ étant un groupe alkylène ou arylène substitué ou non-substitué.

11. Résine époxy selon la revendication 10, **caractérisée en ce que** l'aldéhyde ou la cétone, respectivement, est choisi(e) parmi le groupe constitué de phtaldialdéhyde, de téréphtaldialdéhyde, d'isophtaldialdéhyde et de 1,4-diacétyle benzène.

12. Résine époxy selon l'une des revendications 9 à 11, **caractérisée en ce que** la résine époxy exempte d'halogène utilisée en tant que matière de départ est une résine présentant la formule II 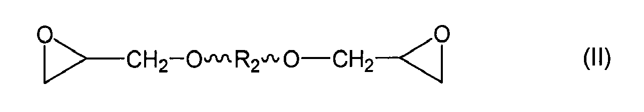 R₂ étant le reste d'un bisphénylène méthane, d'un bisphénylène propane, d'une résine phénol-formaldéhyde ou d'une novolaque substitué(e) ou non substitué(e).

13. Résine époxy selon l'une des revendications 9 à 12, **caractérisée en ce que** le dérivé d'acide de phosphine est un composé présentant les formules IVa-IVe, 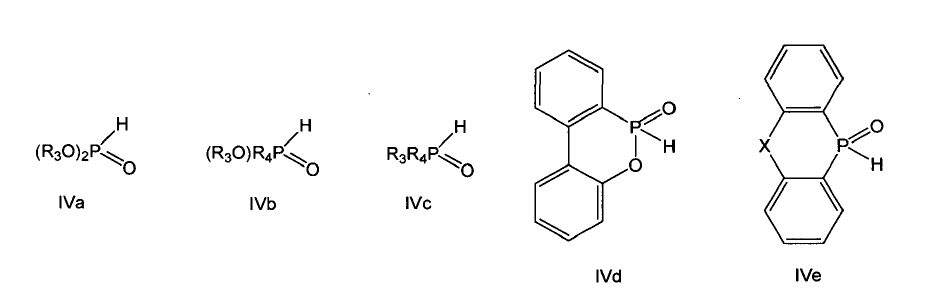
R₃ et R₄ signifiant indépendamment l'un de l'autre un reste alkyle ou aryle substitué ou non-substitué, et
X = O, NH, N-alkyl, S, SO, SO₂ ou CO.

14. Résine époxy selon la revendication 13, **caractérisée en ce que** le dérivé d'acide de phosphine est du 9,10-dihydro-9-oxa-10-phospha-phénanthrène-10-oxyde (DOPO).

15. Résine époxy selon l'une des revendications 9 à 14, **caractérisée par** la formule V, 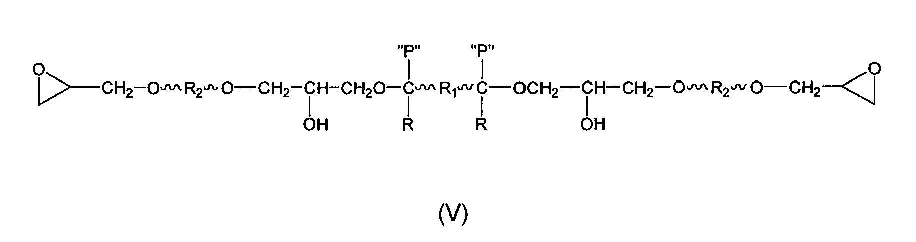 R, R₁ et R₂ ayant les significations mentionnées dans les revendications précédentes, et « P » signifiant le reste d'un dérivé d'acide de phosphine de l'une des formules IVa-IVe, lequel reste après le dégagement de l'atome d'hydrogène directement lié à l'atome de phosphore.

16. Utilisation de la résine époxy selon l'une des revendications 9 à 15 en tant que matière de base pour la réalisation de cartes de circuits imprimés et de circuits imprimés.

17. Produit intermédiaire pour la réalisation de la résine époxy selon l'une des revendications 10 à 15, réalisable par l'addition d'un dérivé d'acide de phosphine à un aldéhyde polyfonctionnel ou une cétone polyfonctionnelle de manière à former un polyol, le dérivé d'acide de phosphine contenant au moins une unité structurelle à P-H actif =PH(O) et étant utilisé dans une quantité équivalente à la polyfonctionnalité de l'aldéhyde ou de la cétone.

18. Produit intermédiaire selon la revendication 17, **caractérisé en ce que** l'aldéhyde polyfonctionnel ou la cétone polyfonctionnelle est un composé difonctionnel présentant la formule I 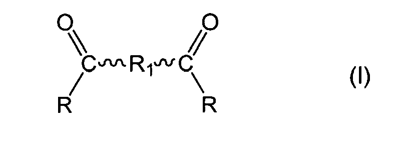 R étant un atome d'hydrogène ou un groupe alkyle ou aryle substitué ou non-substitué, et R₁ étant un groupe alkylène ou arylène substitué ou non-substitué.

19. Produit intermédiaire selon la revendication 18, **caractérisé en ce que** l'aldéhyde ou la cétone, respectivement, est choisi(e) parmi le groupe constitué de phtaldialdéhyde, de téréphtaldialdéhyde, d'isophtaldialdéhyde et de 1,4-diacétyle benzène.

20. Produit intermédiaire selon l'une des revendications 17 à 19, **caractérisé en ce que** le dérivé d'acide de phosphine est un composé présentant les formules IVa-IVe, 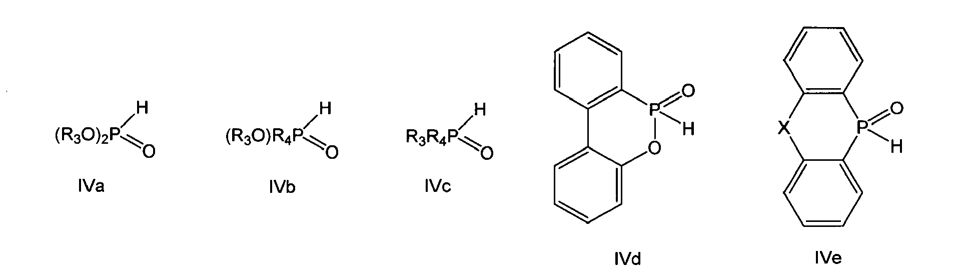
R₃ et R₄ signifiant indépendamment l'un de l'autre un reste alkyle ou aryle substitué ou non-substitué, et
X = O, NH, N-alkyl, S, SO, SO₂ ou CO.

21. Produit intermédiaire selon la revendication 20, **caractérisé en ce que** le dérivé d'acide de phosphine est du 9,10-dihydro-9-oxa-10-phospha-phénanthrène-10-oxyde.
